# EUROPEAN PATENT APPLICATION

(11) **EP 1 890 479 A1**
(43) Date of publication of application: **20.02.2008**
(21) Application number: 06270080.2
(22) Date of filing: 17.08.2006
(51) Int. Cl.: H04N 5/225, G02B 13/00, H01L 31/0232, G02B 1/04

(54) **Imaging Device with Heat-Shielding Means for Inhibiting Thermal Damage to a Lens**

(71) Applicant: STMicroelectronics (Research & Development) Limited, Marlow, Buckinghamshire SL7 1YL (GB)
(72) Inventor: Christison, Eric, Edinburgh, EH3 9AT (GB); Findlay, Ewan, Falkirk, Clackmannanshire FK14 7ES (GB)
(74) Representative: McBride, Peter Hill

(57) **Abstract**

An imaging device (10) comprises an image sensor (20), a lens member (30) adapted to focus external radiation towards the image sensor (20) and heat shielding means adapted to inhibit thermal damage to the lens member (30). The heat shielding means comprises an optical filter (50) interposing the lens member (30) and the external radiation.

## Description

The present invention relates to an imaging device. In particular, but not exclusively, the invention relates to an imaging device which includes a solid state image sensor, and a method of manufacturing the imaging device.

Imaging devices including solid state image sensors are being incorporated into low cost cameras and other handheld devices, such as mobile cellular telephones and personal digital assistants. These handheld devices may have a main function which is unrelated to capturing images. It is desirable to minimise the cost of the imaging devices.

Image sensors require a focussing lens as part of the assembly so that a representation of a subject may be reproduced. The imaging assembly typically also incorporates other components such as additional lens elements, an aperture and an infra-red (IR) filter. The IR filter is present to prevent infrared radiation impinging on the image sensor. Typically, the IR filter is provided at a rear surface of the lens, between the lens and sensor.

Conventionally, prior art imaging assemblies mount individual components in a support structure commonly referred to as a 'barrel'. The lenses and barrel are usually made from low cost materials such as plastic. Generally, prior-art imaging assemblies of this type are intentionally low cost. However, they can suffer from the problem that they do not survive elevated temperatures.

It is beneficial for an imaging device to be able to withstand elevated temperatures. One reason for this is that the solid state image sensors are often subjected to a re-flow solder process. The re-flow solder process requires that the image sensor is passed through a re-flow oven which melts solder deposits to electrically connect various elements. In a fixing operation, prior to passing the image sensor through a reflow oven, components of the image sensor are fixed in place. Because the imaging assembly cannot tolerate the temperature of the reflow oven, it is fixed in place in a separate fixing operation. It would be advantageous if only one fixing operation was needed for all components.

Typically, the components associated with prior art 'barrel' imaging assemblies have optical properties that are modified by elevated temperature and therefore are not suitable for a re-flow solder process.

Often, components are attached to a substrate via a socket or flexible circuit so that they do not have to pass through the re-flow solder process. However, the inclusion of sockets or flexible circuits adds to the cost and size of the assembly. Alternatively, glass rather than plastic lenses may be used. However, such lenses can still be affected by elevated temperatures. They are also more expensive and known to be less accurate.

According to a first aspect of the present invention there is provided an imaging device comprising:
an image sensor;
a lens member adapted to focus external radiation towards the image sensor; and
heat shielding means adapted to inhibit thermal damage to the lens member,
wherein the heat shielding means comprises an optical filter interposing the lens member and the external radiation.

Preferably the optical filter comprises an IR filter. Preferably, the IR filter comprises one or more coatings which inhibit the transmission of infrared electromagnetic radiation.

Preferably the heat shielding means further comprises a housing for at least partially encapsulating the lens member. Preferably the housing is formed from an opaque material. Preferably the housing is formed from a polymer material.

Preferably the heat shielding means further comprises a base member coupled to the housing for at least partially encapsulating the lens member.

Preferably the image sensor comprises a solid state image sensor. Preferably the image sensor comprises a CMOS image sensor. Alternatively, the image sensor may comprise a CCD image sensor.

Preferably the base member comprises a substrate.

Preferably the lens member is formed from a material having a high melting temperature to provide co-operating heat shielding means. Preferably the melting temperature of the material is greater than 200ºC, most preferably greater than 250ºC. Preferably the lens member is at least partially formed from a polymer material. Preferably the lens member is at least partially formed from a modified polycarbonate, such as Sunex^{™}. Alternatively, the lens member may be at least partially formed from a polyetherimide, such as Ultem^{™}.

Preferably the imaging device includes an aperture. Preferably the imaging device includes an opaque coating and the aperture is a passage in the opaque coating. Preferably the opaque coating is provided at the optical filter.

According to a second aspect of the present invention there is provided an imaging device comprising:
an image sensor;
a lens member adapted to focus external radiation towards the image sensor; and
heat shielding means adapted to inhibit thermal damage to the lens member,
wherein the lens member is formed from a material having a high melting temperature to provide the heat shielding means.

Preferably the melting temperature of the material is greater than 200ºC, most preferably greater than 250ºC. Preferably the lens member is at least partially formed from a polymer material.

Preferably the imaging device includes co-operating heat shielding means. Preferably the co-operating heat shielding means comprises an optical filter interposing the lens member and the external radiation.

Preferably the optical filter comprises an IR filter.

Preferably the heat shielding means further comprises a housing for at least partially encapsulating the lens member. Preferably the heat shielding means further comprises a base member coupled to the housing for at least partially encapsulating the lens member.

According to a third aspect of the present invention there is provided a method of manufacturing an imaging device, the device comprising an image sensor and a lens member adapted to focus external radiation towards the image sensor, the method comprising:
interposing an optical filter between the lens member and the external radiation to inhibit thermal damage to the lens member.

Preferably the optical filter comprises an IR filter.

Preferably the method further comprises at least partially encapsulating the lens member within a housing.

Preferably the method includes coupling a base member to the housing for at least partially encapsulating the lens member.

Preferably the method includes forming the lens member from a material having a high melting temperature to further inhibit thermal damage to the lens member. Preferably the melting temperature of the material is greater than 200ºC, most preferably greater than 250ºC. Preferably the lens member is at least partially formed from a polymer material.

Preferably the method includes subjecting the imaging device to a re-flow solder process.

According to a fourth aspect of the present invention there is provided a method of manufacturing an imaging device, the device comprising an image sensor and a lens member adapted to focus external radiation towards the image sensor, the method comprising:
forming the lens member from a material having a high melting temperature to inhibit thermal damage to the lens member.

Preferably the melting temperature of the material is greater than 200ºC, most preferably greater than 250ºC. Preferably the lens member is at least partially formed from a polymer material.

Preferably the method includes interposing an optical filter between the lens member and the external radiation to further inhibit thermal damage to the lens member. Preferably the optical filter comprises an IR filter.

Preferably the method further comprises at least partially encapsulating the lens member within a housing.

Preferably the method includes coupling a base member to the housing for at least partially encapsulating the lens member.

Preferably the method includes subjecting the imaging device to a re-flow solder process.

An embodiment of the present invention will now be described, by way of example only, with reference to the accompanying drawings, in which:
Fig. 1 is a plan view of an imaging device;
Fig. 2 is a sectional side view of the imaging device of Fig. 1;
Fig. 3 is a perspective view of the imaging device of Fig. 1; and
Fig. 4 is a graph of the temperature with respect to time during a typical re-flow solder process.

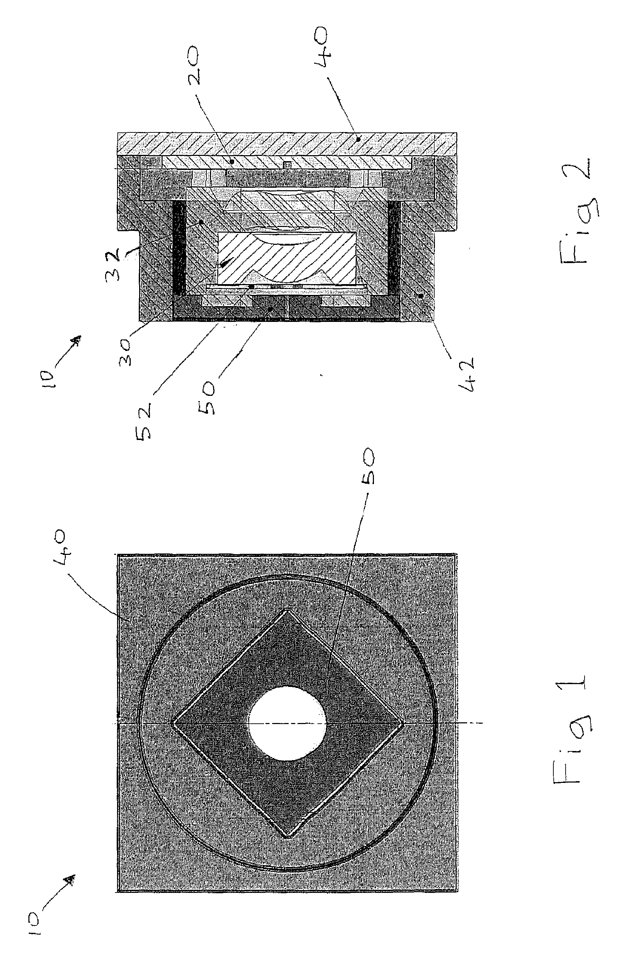

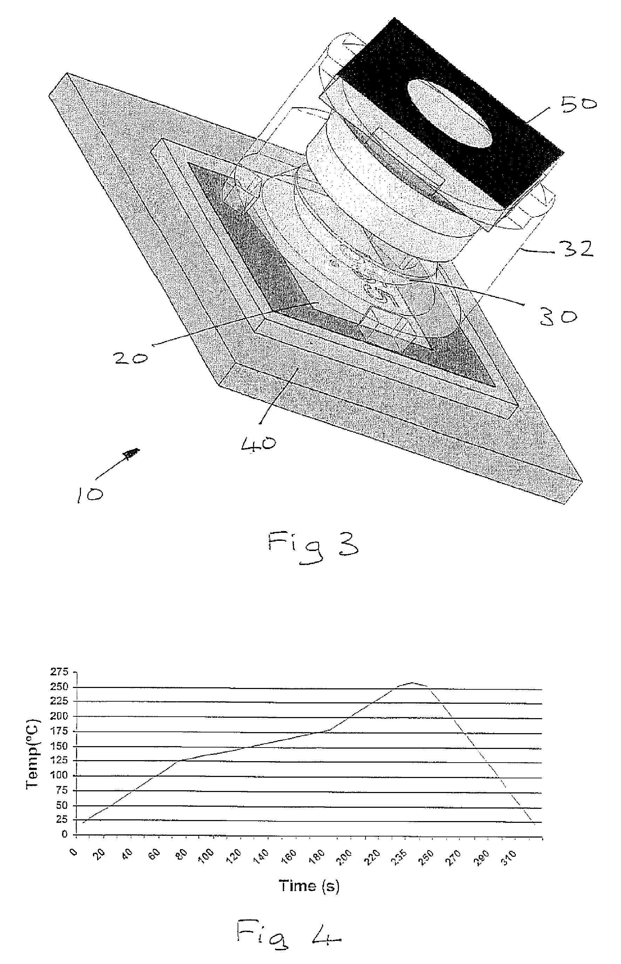

Figs. 1 to 3 show an imaging device 10 which comprises a solid state CMOS image sensor 20 and a lens 30 adapted to focus external light towards the image sensor 20. The image sensor 20 is provided on a base member or substrate 40.

An optical filter in the form of an IR filter 50 is provided in an optical path between the lens 30 and the external light. Also, an aperture 52 is provided at the lens 30. The IR filter 50 provides heat shielding means which inhibits thermal damage to the lens 30, in particular during the manufacturing process. The IR filter 50 is formed by applying to a glass plate a number of coatings of a material which inhibits the transmission of infrared electromagnetic radiation.

The lens 30 is provided in a barrel 32 and the barrel 32 is partially encapsulated in an opaque plastic housing 42 which is fixed to the substrate 40. The housing 42 and substrate 40 also provide heat shielding to the lens 30 as the lens 30 is only exposed to external radiation via the infrared filter 50.

The lens 30 is formed from a polymer material having a relatively high melting temperature. This melting temperature is greater than 200ºC, and preferably greater than 250ºC. One suitable material is a modified polycarbonate, such as Sunex^{™}.

Fig. 4 shows a graph of temperature against time during a typical re-flow solder process. The heating rate is designed to be no greater than 3ºC, and the cooling rate no greater than 6ºC. The peak temperature during the process is about 260ºC. However, the time during which the imaging device 10 is subject to temperatures above 200ºC is less than 90 seconds, and preferably less than 70 seconds. Furthermore, the time during which the imaging device 10 is subject to temperatures above 250ºC is less than 30 seconds, and preferably less than 20 seconds.

The presence and location of the IR filter 50 is sufficient to provide heat shielding means which substantially prevents thermal damage to the lens 30 at high temperatures during the manufacturing process. The relatively high melting temperature of the lens material co-operates with the IR filter 50 to provide additional heat shielding means.

The imaging device 10 of the invention can therefore be subject to the high temperatures of the typical manufacturing process. This eliminates the need for additional sockets or flexible circuits, as well as the additional assembly steps involved with these additional components.

Various modifications and improvements can be made without departing from the scope of the present invention.

## Claims

1. An imaging device (10) comprising:
an image sensor (20);
a lens member (30) adapted to focus external radiation towards the image sensor (20); and
heat shielding means adapted to inhibit thermal damage to the lens member (30),
wherein the heat shielding means comprises an optical filter interposing the lens member (30) and the external radiation.

2. An imaging device (10) as claimed in Claim 1, wherein the optical filter comprises an IR filter (50).

3. An imaging device (10) as claimed in Claim 1 or 2, wherein the heat shielding means further comprises a housing (42) for at least partially encapsulating the lens member (30).

4. An imaging device (10) as claimed in any preceding claim, wherein the heat shielding means further comprises a base member for at least partially encapsulating the lens member (30).

5. An imaging device (10) as claimed in Claim 4, wherein the base member comprises a substrate (40).

6. An imaging device (10) as claimed in any preceding claim, wherein the lens member (30) is formed from a material having a high melting temperature to provide co-operating heat shielding means.

7. An imaging device (10) as claimed in Claim 6, wherein the melting temperature of the material is greater than 200ºC.

8. An imaging device (10) as claimed in Claim 7, wherein the melting temperature of the material is greater than 250ºC.

9. An imaging device (10) as claimed in any preceding claim, wherein the lens member (30) is at least partially formed from a polymer material.

10. An imaging device (10) as claimed in any preceding claim, wherein the image sensor (20) comprises a solid state image sensor.

11. An imaging device (10) as claimed in Claim 10, wherein the image sensor (20) comprises a CMOS image sensor.

12. An imaging device (10) comprising:
an image sensor (20);
a lens member (30) adapted to focus external radiation towards the image sensor (20); and
heat shielding means adapted to inhibit thermal damage to the lens member (30),
wherein the lens member (30) is formed from a material having a high melting temperature to provide the heat shielding means.

13. An imaging device (10) as claimed in Claim 12, wherein the melting temperature of the material is greater than 200ºC.

14. An imaging device (10) as claimed in Claim 13, wherein the melting temperature of the material is greater than 250ºC.

15. An imaging device (10) as claimed in any of Claims 12 to 14, including co-operating heat shielding means comprising an optical filter interposing the lens member (30) and the external radiation.

16. An imaging device (10) as claimed in Claim 15, wherein the optical filter comprises an IR filter (50).

17. An optical pointing device comprising an imaging device (10) according to any preceding claim.

18. An optical pointing device as claimed in Claim 17, wherein the optical pointing device is an optical mouse.

19. A mobile device comprising an imaging device (10) according to any of Claims 1 to 16.

20. A mobile device as claimed in Claim 19, wherein the mobile device is a mobile cellular telephone.

21. A mobile device as claimed in Claim 19, wherein the mobile device is a camera.

22. A method of manufacturing an imaging device (10), the device (10) comprising an image sensor (20) and a lens member (30) adapted to focus external radiation towards the image sensor (20), the method comprising:
interposing an optical filter between the lens member (30) and the external radiation to inhibit thermal damage to the lens member (30).

23. A method as claimed in claim 22, wherein the optical filter comprises an IR filter (50).

24. A method as claimed in Claim 22 or 23, including forming the lens member (30) from a material having a high melting temperature to further inhibit thermal damage to the lens member (30).

25. A method as claimed in Claim 22 or 23, including subjecting the imaging device (10) to a re-flow solder process.

26. A method of manufacturing an imaging device (10), the device (10) comprising an image sensor (20) and a lens member (30) adapted to focus external radiation towards the image sensor (20), the method comprising:
forming the lens member (30) from a material having a high melting temperature to inhibit thermal damage to the lens member (30).

27. A method as claimed in Claim 26, wherein the melting temperature of the material is greater than 200ºC.

28. A method as claimed in Claim 27, wherein the melting temperature of the material is greater than 250ºC.

29. A method as claimed in any of Claims 26 to 28, wherein the lens member (30) is at least partially formed from a polymer material.

30. A method as claimed in any of Claims 26 to 29, including interposing an optical filter between the lens member (30) and the external radiation to further inhibit thermal damage to the lens member (30).

31. A method as claimed in Claim 30, wherein the optical filter comprises an IR filter (50).

32. A method as claimed in any of Claims 26 to 31, including subjecting the imaging device (10) to a re-flow solder process.
